# EUROPEAN PATENT SPECIFICATION

(11) **EP 2 447 737 B1**
(45) Date of publication and mention of the grant of the patent: **29.05.2013**
(21) Application number: 11185534.2
(22) Date of filing: 18.10.2011
(51) Int. Cl.: G01V 1/38

(54) **Method and device for fault analysis and redundancy switching in a power supply for an instrument cable towed in water**
Verfahren und Vorrichtung zur Fehleranalyse und Redundanzschaltung in einer Stromversorgung für ein in Wasser gespannten Instrumentenkabel
Procédé et dispositif pour l'analyse de défauts et la commutation de la redondance dans une alimentation électrique pour un câble d'instrument tracté dans l'eau

(30) Priority: 28.10.2010 NO 20101515
(43) Date of publication of application: 02.05.2012
(73) Proprietor: KONGSBERG SEATEX AS, 7462 Trondheim (NO)
(72) Inventor: Westrum, Herleif, 7024 Trondheim (NO)
(74) Representative: Curo AS

(56) References cited:
- US-A- 4 023 140
- US-A- 5 883 856
- US-A1- 2003 016 587

## Description

The present invention relates to a method for fault analysis and redundancy switching in a power supply for an instrument cable towed in water, according to the preamble of claim 1.

The present invention also relates to a device for fault analysis and redundancy switching, especially a device with redundancy for power control and data transfer, according to the preamble of claim 8.

### Background

One method for obtaining seismic data about the ground structure below the seabed is to use hydrophones in instrument cables towed behind a survey vessel, known as seismic cables, to register reflections from the ground structure after an air gun has been utilized to generate a shock wave into the ground. The seismic cables consist of a number of conductor pairs that are used for transmitting data and powering of electronic equipment along the seismic cable.

At regular distances along the seismic cable there is normally arranged a control device called "bird", which is used for steering the instrument cable in the water. Advanced birds can have up to four movable wings which are used for position control of the instrument cable in the water. Moreover, advanced birds will contain internal batteries that can be used to control the bird if power is lost from the main source feeding the instrument cables. Birds also normally contain more or less sophisticated parts as motors, gears, acoustic transducers and electronic control circuits which may communicate with a central computer onboard the survey vessel.

An instrument cable may be more than several thousand meters long and consists of a number instrument cable segments and birds. The birds are usually attached to the instrument cables between two segments, e.g. at intervals of 200 to 300 meters. Instrument cables typically have more than twelve conductors arranged in more than six balanced conductor pairs used for power feeding and data transmission.

Due to loss in the instrument cables it is common to operate the instrument cables at fairly high voltage levels. Voltages in the range of 400 to 600 volts are normally used. The high voltage can be lethal to humans if applied directly to the human body. The wet and conductive environment onboard a seismic vessel will contribute to increased danger for electrical shocks and it is therefore very important to control the integrity of the seismic cables and equipment before such high voltages are applied to the equipment. Power supplies for such equipment therefore normally include a Ground Fault Indicator (GFI) as an indicator of system health.

It is evident that the instrument cables will be subject to high forces when towed at some speed through the water. Frictional forces on the instrument cable and control forces from the bird will both contribute to a stretching force that the instrument cable has to sustain.

Taking into account the length of the instrument cable this may lead to very high stretching forces in the first segments of the instrument cable.

As the instrument cable is stretched in the seawater, some water may enter the interior of the instrument cable. If the instrument cable also has some minor mechanical damage, inflow of salt water can develop to a major problem. Leakage of water trough connectors may be another problem degrading the integrity and quality of the instrument cable system.

Salt water has high conductance and may further penetrate into the basic conductor pairs themselves. If a salt water bridge or humidity track is developed between the conductors in a pair or between conductor pairs it can substantially influence the characteristics of the instrument cable. Humidity or water in the instrument cable will lead to uncontrolled leak currents that may upset the basic operation of the electronics or lead to uncontrolled earth leak currents that can lead to hazardous situations onboard the survey vessel. It is therefore of prime importance to detect and remove such faults as early as possible.

The instrument cables, such as streamer cables, are normally stored on large reels onboard the survey vessel before being launched into the sea. A method that can detect faults in instrument cables before they are launched will be very helpful to minimize service time. If the fault is detected only after the instrument cable is in the water, the service and repair time will increase significantly. Moreover, in the time needed for repair, the seismic vessel is out of operation.

From US 2008310298 it is known a streamer or cable for use in subterranean surveying which includes a communication link, a plurality of network nodes interconnected by the communication link, where each of the plurality of network nodes is configured to perform a self-test to detect a fault condition of the corresponding network node, and bypass switches to bypass faulty one or more network nodes.

US 2008100307 describes a cable fault detection component which receives input data indicative of a fault in an electrical power system. The component analyzes the input data to determine if the fault is indicative of a self-clearing cable fault and generates corresponding output data.

From US 5883856 it is known an improved bottom cable for a seismic marine data acquisition system. The bottom cable includes a cable section having a bus. The cable, along with the cable section and bus, are used to electrically connect a master control unit to first and second modules. The bus includes first and second switches located near opposite ends of the bus. In this way, if a leak occurs in the bus, the first and second switches can be opened, thereby electrically isolating the bus and stopping the leak.

US 2003117025 describes an underwater cable arrangement which includes systems and method for distributing and/or transferring power and/or data to internal devices and external devices disposed along an underwater cable. Under water coupling systems and underwater electrical devices may be used in the distribution and/or transfer of the power and/or data.

Prior art fails to provide a device or method for detecting hazardous situations that may arise due to defective instrument cable sections and equipment failure. Prior art also fails to present a device or method to address the issues regarding early detection of faults and a device and method to operate even if a fault is detected on an instrument cable in operation.

There is accordingly a need for a device and method which will significantly contribute to higher safety, improved failure analysis and shorter time to service and repair for instrument cables.

### Object

The main object of the present invention is to provide a device and method which solves the problems of prior art.

It is further an object of the invention to provide a device and method for detecting hazardous situations due to uncontrolled ground loops that may arise due to defective instrument cable sections and equipment failure.

It is an object of the invention to provide a device and method to address the issues regarding early detection of faults.

An object of the invention is to provide a device and method which makes it possible to operate, i.e. continue a survey, even if a fault is detected on an instrument cable or equipment in operation.

It is finally an object of the invention to provide a device and method which significantly will result in higher safety, improved failure analysis and shorter time to service and repair for instrument cables, birds and other equipment.

### The invention

A method according to the invention is described in claim 1. Advantageous features of the method are described in claims 2-7.

A device according to the invention is described in claim 8. Advantageous features of the invention are described in claims 9-16.

An instrument cable has a number of conductors arranged in pairs, typically the instrument cable is provided with a number of conductors arranged in a number of balanced conductor pairs used for power feeding and data transmission. The balanced conductor pairs are fed from a power supply and a power supply control unit onboard a survey vessel. Usually a number of these conductor pairs are dedicated for power and a number of these conductor pairs are dedicated for data transfer. This is controlled by a control unit onboard the vessel and can be changed according to preferences. A conductor pairs can also be dedicated to transfer both power and data.

According to the invention there is provided a device for fault analysis and redundancy switching (DFARS) to provide increased redundancy and safe operation of the multi-section instrument cable. The DFARS is provided with means for controlling the main power of the conductor pairs, i.e. control main power and data transfer to a segment of the instrument cable and possibly birds attached to that segment. Preferably these means are one or more main switches, one for each conductor pair in the instrument cable, or one or more multi main switches for a number of conductor pairs.

The DFARS is further provided with means for switching between conductor pairs in the instrument cable. These means are preferably one or more crossover switches, one for each conductor pair in the instrument cable, or one or more multi crossover switches for a number of conductor pairs.

The DFARS may also further include means local ground fault detection by means of local measurement of current/voltage for each conductor pair and considering if there is dissymmetry between positive and negative conductor. This information may be used to know if the fault is located in the instrument cable segment or in a control device for controlling the instrument cable or other equipment arranged to the instrument cable.

For control of the means for controlling the main power of the conductor pairs and for controlling the means for pair switching the DFARS is provided with control unit and a time delay unit which may be either be software implemented or hardware implemented.

The DFARS is preferably provided with communication means for communicating with the central control unit onboard the vessel, which controls the power supply and data transfer of the instrument cable.

The DFARS according to the invention may be arranged at several locations in relation to the power supply for the instrument cable, such as:
- integrated in or arranged to a control device for controlling the position of an instrument cable,
- integrated in or arranged to the instrument cable, such as in relation to connectors for connection of instrument cable sections, or
- integrated in or arranged to equipment arranged to the instrument cable.

As mentioned above the control unit of the DFARS is provided with a control unit which can be integrated in the DFARS, the control unit can be integrated as a separate unit in a control device for an instrument cable, or the control unit may also be a control unit of the control device. The operation of the DFARS may also be controlled based on command messages from a central control unit arranged onboard the survey vessel so that no dedicated control device is needed in the DFARS.

By means of the above described DFARS controlled fault detection may be performed on the multi-section instrument cable. It is also possible to provide continued operation even if a conductor pair has a fault.

The invention uses two strategies, one for fault detection and one for control if a fault is detected.

The fault detection strategy involves that the DFARS, which preferably is arranged in connection with each segment of the instrument cable, applies a time delay of preset time before power is applied to the next instrument cable segment of the instrument cable. This is done by delayed switching of the conductor pairs in the control device before power is supplied to the next instrument cable segment. Each control device (if present) and the corresponding instrument cable segment are therefore set in operation in a specific timeslot which can be detected by a central control unit onboard the vessel. By measuring the increase in current from the main power supply in the corresponding timeslot, by means of the central control unit on the survey vessel, it will be possible to detect if the control device and the following segment consumes the correct and specified current level. If the current level is not according to preset values the power supply can be switched to another conductor pair in the instrument cable segment, thereby obtaining redundant power feeding solution. The fault detection strategy preferably also includes considering local measurements of current/voltage for each conductor pair for considering if there is dissymmetry between positive and negative conductor to know if the fault is located in the instrument cable segment or in a control device for controlling the instrument cable or other equipment arranged to the instrument cable.

The level of the fault current is indicative of the hazard situation regarding dangerous voltages. If the fault current is very high, it is likely that there are some uncontrolled earth loops that may lead to dangerous voltages onboard. Detecting this situation instantaneously after power has been applied to the instrument cable segment can avoid dangerous situations for operators and personnel onboard.

The control strategy involves controlling the power distribution path directly if a fault is present. If a fault situation is detected, the DFARS itself can switch the power over to a redundant conductor pair. Moreover, this can also be done by a central control unit onboard the survey vessel by transmitting a control message to the DFARS.

Accordingly a method for fault detection and control may be summarized in the following steps:
a) Supplying power to DFARS number x and segment number y of the instrument cable.
b) Measuring total current level from a main power supply,
c) Evaluate the measured current level according to preset values, and
   c1) if the measured current is not according to preset values switch the power supply to another conductor pair by means of the DFARS and repeat step a)-c),
   c2) If the measured current level is according to preset values, increase x and y with one and repeat steps a)-c),
d) Repeat steps a)-c) for all DFARS and instrument cable segments.

Steps a) includes that each DFARS applies a time delay of a preset time before power is applied to the next instrument cable segment by means of delayed switching of the conductor pairs before voltage is supplied to the next cable segment.

Step b) includes measuring the current level in a corresponding timeslot for detecting if the DFARS and the following instrument cable segment consume correct and specified current level.

Step b) may further include local voltage and current measurements by the DFARS.

Step c) includes that if the measured current level is outside the preset values, the control devices by means of the integrated control unit, the specified control unit or a command message from a central control unit onboard the survey vessel switch the power distribution path to another conductor pair, i.e. a redundant conductor pair.

Step c) may further include considering local current and voltage measurements to establish whether the fault is present in the instrument cable segment, a control device or other equipment arranged to the instrument cable.

Step c) may further include that if a fault is detected; check if the conductor pair may be used for data transmission. If the conductor pair may be used for data transmission the central control unit onboard the survey vessel configures the conductor pair for data transmission.

The above described fault analysis may be performed as "on reel testing", i.e. before deployment, which would make it easy to replace faulty components before deployment. The fault analysis may be performed as the instrument cable is deployed into the sea so that each segment and accompanying equipment is tested subsequently. The fault analysis may also be tested during operation.

In this way early detection of fault situations may be provided at any stage in an operation. By redundant switching in case of faulty elements continued operation at any stage of the operation is provided.

If a fault is detected, the conductor pair may be used for data transmission even if power feeding is faulty, as long as conductor pair does not broken, i.e. if the resistance is not infinite.

Further details and preferable features of the invention will appear from the following example description.

### Example

The invention will below be described in further detail by reference to the accompanying figures, where:
Figure 1 shows a simplified view of a power supply onboard a survey vessel feeding a chain of control devices and instrument cable segments,
Figure 2 shows a control device of prior art,
Figure 3 is a basic schematic of device for fault analysis and redundancy switching according to the invention, and
Figure 4a-d shows an example of fault detection.

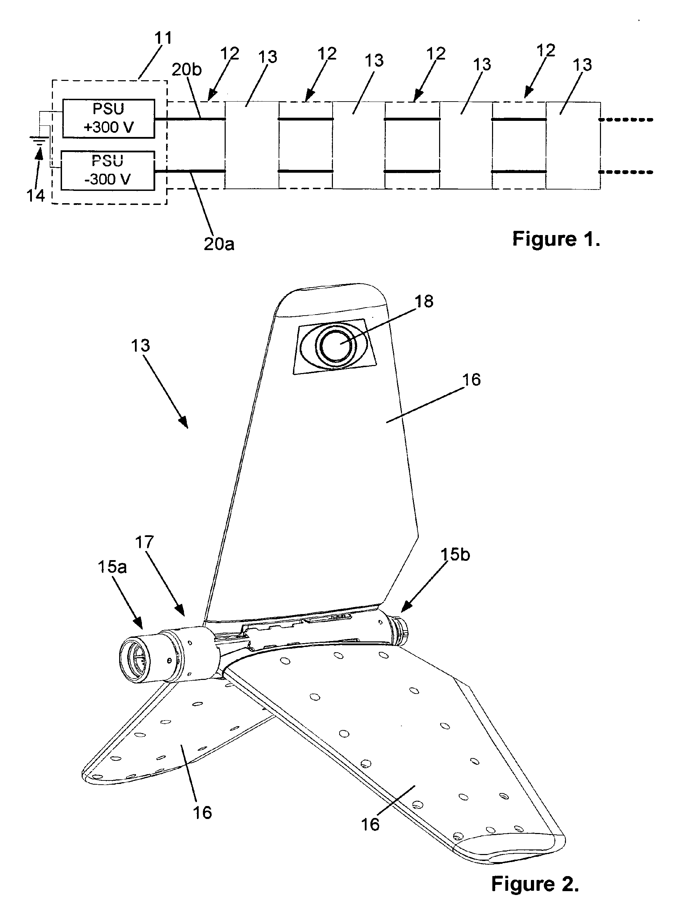

Reference is now made to Figure 1 which shows a power supply 11 on a survey vessel feeding a chain of instrument cable segments 12, and where control devices 13 are arranged between instrument cable segments 12 for steering the instrument cable. The power supply is connected to a common ground potential 14, for example vessel ground, forming a positive and negative potential for a conductor pair.

Reference is now made to Figure 2 which shows an example of a control device 13 of prior art, for example as described in Norwegian patents No. 328856 and No. 329190 in the name of the applicant. The control device 13 is provided with connection means 15a-b adapted for mechanical and electrical connection of the control device 13 in series between two adjacent instrument cable sections 12 of a multi-section instrument cable/streamer. The control device 13 includes three similar wings 16, for example, so-called smart wings, where all electronics and sensors are enclosed in the wings, which wings 16 are evenly distributed around a main body 17, and is a so-called three-axis bird. The wings 16 are preferably designed so that a quick-release coupling to the main body 17, both mechanically and electrically.

The main body 17 is preferably arranged so that the feed-through of conductors between the instrument cable sections 12 are separated from the wing mechanisms, drive means, control means and sensors. This is to avoid function failure in case of mechanical damage of the control device 13, e.g. leakage. The control device 13 may be arranged for wireless transfer of data and power between the main body 17 and wings 16. The control device 13 may further be provided with acoustic transducers 18 for acoustic distance measurements.

Reference is again made to Figure 1. For the sake of clarity the invention is described for an instrument cable having two balanced conductor pairs 20a-b used for transmission of data and power feeding of the control devices 13 and instrument cable segments and equipment arranged thereto. The control devices 13 are provided with internal power supplies and batteries that can be charged from either conductor pair 20a-b. The control device 13 is preferably provided with an onboard control unit and software for control and steering. The balanced conductor pairs 20a-b are fed from the power supply 11 and a central control unit (not shown) onboard the survey vessel. The voltage level is typically 600 volts balanced, i.e. plus/minus 300 volts with respect to chassis ground on the power supply 11. The 600 V DC power supply is earthed 14 with chassis to safety earth onboard the survey vessel.

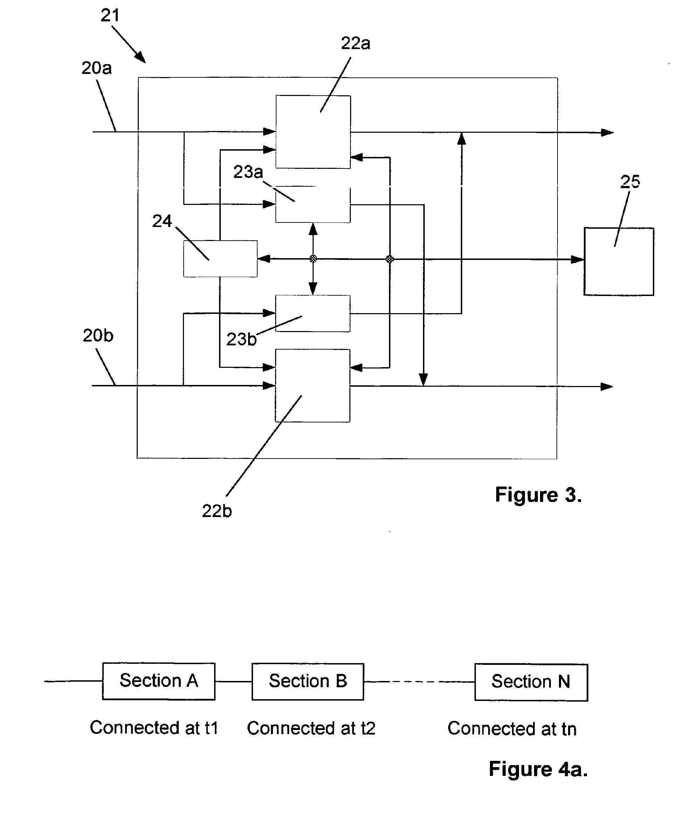

Reference is now made to Figure 3 basic schematic of a device for fault analysis and redundancy switching 21 (DFARS) according to the invention. According to a first embodiment the DFARS are integrated in or arranged to a control device 13 as described above. The DFARS 21 includes means for controlling the main power of the conductor pairs 20a-b which in the form of main switches 22a-b, one for each conductor pair 20a-b, respectively, or one or more multi-switches for a number of conductor pairs 20a-b. The DFARS 21 further includes means for switching between conductor pairs 20a-b in the form of crossover switches 23a-b, one for each conductor pair 20a-b, respectively, or one or more multi-crossover switches for a number of conductor pairs 20a-b. The DFARS 21 further includes means for controlling the switches 22a-b and 23a-b in the form of a time delay unit 24 which may be either be software implemented or hardware implemented and a control unit 25. The control unit 25 may arranged as a separate unit in the control device 13 or be integrated in the control unit of the control devices 13. The time delay unit 24 is controlled by the control unit 25.

The DFARS 21 is further preferably provided with means for local ground fault detection in the form of means for measuring current and/or voltage locally for each conductor pair for considering if there is dissymmetry between positive and negative conductor 20a-b to know if the fault is located in the instrument cable segment 12 or in a control device 13 for controlling the instrument cable or other equipment arranged to the instrument cable.

According to a second embodiment the DFARS 21 is integrated in or arranged to the instrument cable, such as in relation to connectors for connection of instrument cable sections.

According to a third embodiment the DFARS 21 is integrated in or arranged to equipment arranged to the instrument cable.

How the DFARS 21 works will now be described with the basis of the first embodiment.

The DFARS 21 in connection with each control device 13 applies a preset time delay before power is applied to the next segment 12 of the instrument cable by means of the time delay unit 24 controlling the main switches 22a-b. This is done by delayed switching of the conductor pairs 20a-b before voltage is supplied to the next instrument cable segment 12. Each control device 13 and the corresponding instrument cable segment 12 is therefore set in operation in a specific timeslot which can be detected by a central computer onboard the survey vessel. By measuring the increase in current from the main power supply 11 in the corresponding timeslot it will be possible to detect if the control device 13 and the following seismic cable segment 12 consumes the correct and specified current level. If the current level is not according to preset values, the power feed can be switched to another conductor pair 20a-b in the control device 13/ DFARS 21 by means of the crossover switches 23a-b, thereby obtaining a redundant power feeding solution.

As the DFARS 21/control device 13 is provided with a control unit 25 with internal processor, software and communication devices, it is possible to control the power distribution path directly from the control unit 25 in the DFARS 21/control device 13. If a fault situation is detected, the DFARS 21 itself can switch the power over to a redundant conductor pair 20a-b. Moreover, this can also be done by the central control onboard the vessel by transmitting a command message to the DFARS 21. As mentioned above the means for current and voltage measurements also provides valuable information for considering if it is the instrument cable segment, control device or other equipment which are having a fault.

Reference is now made to Figure 4a-d which shows an example of fault detection according to the invention. Figure 4a illustrates that an instrument cable segment 12 and control device 13 are considered as one section to be tested. As the sections are successively powered from the survey vessel by means of the main switches 22a-b, one can measure a total current level for the system as the sections are powered successively. The sections are powered successively by a certain time preset time delay. As the current level per section initially are known, a deviation from the normal current level will indicate that something is wrong with the actual section, i.e. instrument cable segment 12, control device 13 or both.

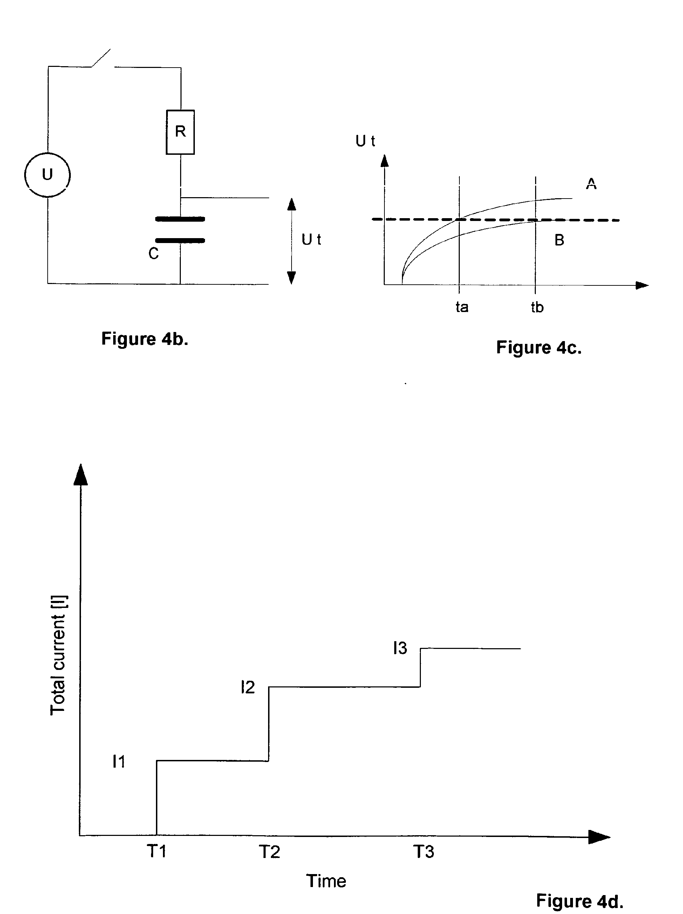

The time delay may, for example, be arranged by charging of a RC network, as shown in Figure 4b. As the main switches 22a-b are activated or voltage supplied to the RC network, the voltage over C will rise exponentially, as shown in Figure 4c. As a preset voltage over C is achieved, the powering of the section, i.e. instrument cable segment 12 and control device 13, is triggered.

As the supplied voltage will be reduces as the distance to the actual section, i.e. instrument cable segment 12 and control device 13, increases due to loss in the conductor pairs 20a-b, it will take longer time for each section, i.e. instrument cable segment 12 and control device 13, to reach the point of triggering. As can be seen in Figure 4b, section A is powered first and reaches the time of triggering at ta. Section B will have lower input voltage and need more time for reaching time of triggering tb. The current level will thus follow a step-like curve, as shown in Figure 4d, where each step will be some longer than the preceding, i.e. t2-t1 < t3 - t2 and so on. The step level will however be constant as each section will consume the same current. If the step level becomes too low, as indicated for a third section at time t3 in Figure 4d, this will indicate that there is a fault condition in a third section and one can use the crossover switches 23a-b to choose another conductor pair 20a-b for power supply. After a new conductor pair 20a-b are chosen, one performs the test again to see if the fault is still present.

This means that one according to the invention use switches, time delay and CPU control to obtain redundancy and fault detection in the instrument cable and control device 13. Output voltage appears only after a time delay after voltage is applied at the input.

To establish whether the fault is present in the instrument cable segment 12, control device 13 or other equipment arranged to the instrument cable one considers the local current and/or voltage measurements. If there is dissymmetry between positive and negative conductor 20a-b the fault is in the cable segment. Faults in the control device 13 can be traced using measurement of voltages and currents in the control device 13.

## Claims

1. Method for fault detection and control of a multi-section instrument cable, such as a marine seismic streamer, which multi-sectional instrument cable includes a number of conductor pairs for power supply and data transfer, where devices for fault analysis and redundancy switching is arranged in connection with a power supply for the instrument cable sections, **characterized in that** the method includes the following steps:
a) supplying power to device for fault analysis and redundancy switching number x and instrument cable section number y along the instrumented cable,
b) measuring total current and voltage level from a main power supply for the instrumented cable and performing local voltage and current measurements by the devices for fault analysis and redundancy switching arranged along the instrument cable,
c) evaluating the measured current and voltage level according to preset values, and
c1) if the measured current level, voltage level or both is not according to preset values switch the power supply to another conductor pair by means of the device for fault analysis and redundancy switching and repeat step a)-c), or
c2) if the measured current and voltage levels are according to preset values, increase x and y with one and repeat steps a)-c),
d) repeat step a)-c) for all devices for fault analysis and redundancy switching and instrument cable sections.

2. Method according to claim 1, **characterized in that** steps a) includes that each device for fault analysis and redundancy switching applies a time delay of a preset time before power is applied to the next instrument cable section by means of delayed switching of the conductor pairs before voltage is applied to the next cable section.

3. Method according to claim 1, **characterized in that** step b) includes measuring total current and voltage level in a corresponding timeslot for detecting if the device for fault analysis and redundancy switching and following instrument cable section consumes correct and specified current and voltage level.

4. Method according to any of the claims 1-3, **characterized in that** step c) further includes considering local current and voltage measurements to establish whether the fault is present in the instrument cable section, a control device or other equipment arranged to the instrument cable.

5. Method according to any of the claims 1-4, **characterized in that** step c) further include that if a fault is detected; check if the conductor pair may be used for data transmission.

6. A device (21) for fault analysis and redundancy switching for a multi-section instrument cable, such as a marine seismic streamer, which multi-sectional instrument cable includes a number of conductor pairs (20a-b) for power supply and data transfer, which device (21) for fault analysis and redundancy switching is arranged in connection with a power supply for the multi-section instrument cable, **characterized in that** the device (21) for fault analysis and redundancy switching is provided with:
- means (22a-b) for controlling the power supply instrumented cable sections, and that a time delay unit (24) is connected to the means (22a-b), which means (22a-b) and time delay unit (24) are arranged to successively supply power to instrumented cable sections and devices (21) for fault analysis and redundancy switching along the instrumented cable,
- means (23a-b) for switching the power supply to another conductor pair (20a-b) in the instrument cable section if a fault is detected, and
- means for local measurement of current and voltage in the conductor pairs (20a-b).

7. Device according to claim 6, **characterized in that** the means (22a-b) for controlling the power are one or more main switches, one for each conductor pair (20a-b), or one or more multi main switches for a number of conductor pairs (20a-b).

8. Device according to claim 6, **characterized in that** the means (23a-b) for switching between conductor pairs (20a-b) in the instrument cable are one or more crossover switches, one for each conductor pair (20a-b), or one or more multi crossover switches for a number of conductor pairs (20a-b).

9. Device according to claim 6, **characterized in that** the time delay unit (24) is either software implemented or hardware implemented.

10. Device according to any one of the claims 6-9, **characterized in that** device (21) for fault analysis and redundancy switching includes a control unit (25), to which the means (22a-b) for controlling the power, means (23a-b) for switching between conductor pairs (20a-b) and time delay unit (24) are arranged.

11. Device according to any one of the claims 6-10, **characterized in that** the device (21) for fault analysis and redundancy switching is
- integrated in or arranged to a control device (13) for controlling the position of an instrument cable,
- integrated in or arranged to the instrument cable, such as in relation to connectors for connection of instrument cable sections, or
- integrated in or arranged to equipment arranged to the instrument cable.

12. Device according to any of the claims 6-11, **characterized in that** the device (21) for fault analysis and redundancy switching are provided with means for communicating with a central control unit arranged for controlling power supply and data transfer to the instrument cable, and measuring total current and voltage level of the instrument cable.

## Patentansprüche

1. Verfahren zur Fehlerdetektion und Steuerung eines Mehrfachabschnitt-Instrumentenkabels wie etwa eines seismischen Meeres-Streamers, wobei das Mehrfachabschnitt-Instrumentenkabel zahlreiche Leiterpaare für die Stromversorgung und die Datenübertragung enthält, wobei Vorrichtungen zur Fehleranalyse und Redundanzumschaltung in Verbindung mit einer Stromversorgung für die Instrumentenkabel-Abschnitte angeordnet sind, **dadurch gekennzeichnet, dass** das Verfahren die folgenden Schritte umfasst.
a) Zuführen von Leistung zu einer Vorrichtung zur Fehleranalyse und Redundanzumschaltung mit Nummer x und zu einem Instrumentenkabel-Abschnitt mit Nummer y längs des Instrumentenkabels,
b) Messen des Gesamtstrom- und des Gesamtspannungspegels von einer Hauptstromversorgung für das Instrumentenkabel und Ausführen lokaler Spannungs -und Strommessungen durch die Vorrichtungen zur Fehleranalyse und Redundanzumschaltung, die längs des Instrumentenkabels angeordnet sind,
c) Bewerten der gemessenen Strom- und Spannungspegel in Übereinstimmung mit im Voraus festgelegten Werten, und
c1) falls der gemessene Strompegel und/oder der gemessene Spannungspegel nicht mit im Voraus festgelegten Werten übereinstimmt, Umschalten der Stromversorgung zu einem weiteren Leiterpaar mittels der Vorrichtung zur Fehleranalyse und Redundanzumschaltung und Wiederholen der Schritte a)-c), oder
c2) falls die gemessenen Strom- und Spannungspegel mit im Voraus festgelegten Werten übereinstimmen, Erhöhen von x und y um eins und Wiederholen der Schritte a)-c),
d) Wiederholen der Schritte a)-c) für alle Vorrichtungen zur Fehleranalyse und Redundanzumschaltung und Instrumentenkabel-Abschnitte.

2. Verfahren nach Anspruch 1, **dadurch gekennzeichnet, dass** der Schritt a) umfasst, dass jede Vorrichtung zur Fehleranalyse und Redundanzumschaltung eine Zeitverzögerung um eine im Voraus festgelegte Zeit anwendet, bevor an den Instrumentenkabel-Abschnitt Leistung angelegt wird, mittels eines verzögerten Umschaltens der Leiterpaare, bevor an den nächsten Kabelabschnitt eine Spannung angelegt wird.

3. Verfahren nach Anspruch 1, **dadurch gekennzeichnet, dass** der Schritt b) das Messen des Gesamtstrom- und des Gesamtspannungspegels in einem entsprechenden Zeitschlitz umfasst, um zu detektieren, ob die Vorrichtung zur Fehleranalyse und Redundanzumschaltung und der folgende Instrumentenkabel-Abschnitt die korrekten und spezifizierten Strom-und Spannungspegel verbrauchen.

4. Verfahren nach einem der Ansprüche 1-3, **dadurch gekennzeichnet, dass** der Schritt c) ferner das Berücksichtigen lokaler Strom- und Spannungsmessungen umfasst, um zu ermitteln, ob in dem Instrumentenkabel-Abschnitt, in einer Steuervorrichtung oder in einem anderen Gerät, die an dem Instrumentenkabel angeordnet sind, ein Fehler vorhanden ist.

5. Verfahren nach einem der Ansprüche 1-4, **dadurch gekennzeichnet, dass** der Schritt c) ferner umfasst, dass dann, wenn ein Fehler detektiert wird, geprüft wird, ob das Leiterpaar für eine Datenübertragung verwendet werden kann.

6. Vorrichtung (21) zur Fehleranalyse und Redundanzumschaltung für ein Mehrfachabschnitt-Instrumentenkabel wie etwa einen seismischen Meeres-Streamer, wobei das Mehrfachabschnitt-Instrumentenkabel zahlreiche Leiterpaare (20a-b) für die Stromversorgung und die Datenübertragung enthält, wobei die Vorrichtung (21) zur Fehleranalyse und Redundanzumschaltung in Verbindung mit einer Stromversorgung für das Mehrfachabschnitt-Instrumentenkabel angeordnet ist, **dadurch gekennzeichnet, dass** die Vorrichtung (21) zur Fehleranalyse und Redundanzumschaltung versehen ist mit:
- Mitteln (22a-b) zum Steuern der Stromversorgung der Instrumentenkabel-Abschnitte, wobei mit den Mitteln (22ab) eine Zeitverzögerungseinheit (24) verbunden ist, wobei die Mittel (22a-b) und die Zeitverzögerungseinheit (24) dafür ausgelegt sind, an Instrumentenkabel-Abschnitte und Vorrichtungen (21) zur Fehleranalyse und Redundanzumschaltung nacheinander längs des Instrumentenkabels Leistung zuzuführen,
- Mitteln (23a-b) zum Umschalten der Stromversorgung zu einem weiteren Leiterpaar (20a-b) in den Instrumentenkabel-Abschnitt, falls ein Fehler detektiert wird, und
- Mitteln zum lokalen Messen von Strom und Spannung in den Leiterpaaren (20a-b).

7. Vorrichtung nach Anspruch 6, **dadurch gekennzeichnet, dass** die Mittel (22a-b) zum Steuern der Leistung ein oder mehrere Hauptschalter, einer für jedes Leiterpaar (20a-b), oder ein oder mehrere Mehrfachhauptschalter für zahlreiche Leiterpaare (20a-b) sind.

8. Vorrichtung nach Anspruch 6, **dadurch gekennzeichnet, dass** die Mittel (23a-b) zum Umschalten zwischen Leiterpaaren (20a-b) in dem Instrumentenkabel ein oder mehrere Kreuzungsschalter für zahlreiche Leiterpaare (20ab) sind.

9. Vorrichtung nach Anspruch 6, **dadurch gekennzeichnet, dass** die Zeitverzögerungseinheit (24) entweder durch Software oder durch Hardware implementiert ist.

10. Vorrichtung nach einem der Ansprüche 6-9, **dadurch gekennzeichnet, dass** die Vorrichtung (21) zur Fehleranalyse und Redundanzumschaltung eine Steuereinheit (25) enthält, mit der die Mittel (22a-b) zum Steuern der Leistung, die Mittel (23a-b) zum Umschalten zwischen Leiterpaaren (20a-b) und die Zeitverzögerungseinheit (24) verbunden sind.

11. Vorrichtung nach einem der Ansprüche 6-10, **dadurch gekennzeichnet, dass** die Vorrichtung (21) zur Fehleranalyse und Redundanzumschaltung
- in eine Steuervorrichtung (13) zum Steuern der Position eines Instrumentenkabels integriert oder damit verbunden ist,
- in das Instrumentenkabel integriert oder damit verbunden ist, etwa in Bezug zu Verbindern zum Verbinden von Instrumentenkabel-Abschnitten, oder
- in ein Gerät, das mit dem Instrumentenkabel verbunden ist, integriert oder damit verbunden ist.

12. Vorrichtung nach einem der Ansprüche 6-11, **dadurch gekennzeichnet dass** die Vorrichtung (21) zur Fehleranalyse und Redundanzumschaltung mit Mitteln versehen ist, um mit einer Zentraleinheit zu kommunizieren, die dafür ausgelegt ist, die Stromversorgung und die Datenübertragung zu dem Instrumentenkabel zu steuern, und um den Gesamtstrom- und den Gesamtspannungspegel des Instrumentenkabels zu messen.

## Revendications

1. Procédé pour la détection de défaillance et la commande d'un câble d'instrument à sections multiples, tel qu'une flute sismique marine, lequel câble d'instrument à sections multiples comprend un nombre de paires de conducteurs pour l'alimentation en énergie électrique et le transfert de données, où des dispositifs pour l'analyse de défaillance et la commutation de redondance sont agencés en association avec une alimentation en énergie électrique pour les sections de câble d'instrument, **caractérisé en ce que** le procédé comprend les étapes suivantes :
a) la fourniture d'énergie électrique au dispositif pour l'analyse de défaillance et la commutation de redondance numéro x et à la section de câble d'instrument numéro y le long du câble d'instrument,
b) la mesure du niveau total de courant et de tension à partir d'une alimentation principale en énergie électrique pour le câble d'instrument et la réalisation de mesures locales de tension et de courant par les dispositifs pour l'analyse de défaillance et la commutation de redondance agencés le long du câble d'instrument,
c) l'évaluation du niveau mesuré de courant et de tension selon des valeurs préréglées, et
c1) si le niveau mesuré de courant, le niveau mesuré de tension ou les deux ne sont pas selon des valeurs préréglées, la commutation de l'alimentation en énergie électrique à une autre paire de conducteurs au moyen du dispositif pour l'analyse de défaillance et la commutation de redondance et la répétition des étapes a) à c), ou
c2) si les niveaux mesurés de courant et de tension sont selon des valeurs préréglées, l'augmentation de x et de y d'un et la répétition des étapes a) à c),
d) la répétition des étapes a)-c) pour tous les dispositifs pour l'analyse de défaillance et la commutation de redondance et toutes les sections de câble d'instrument.

2. Procédé selon la revendication 1, **caractérisé en ce que** l'étape a) comprend l'application, par chaque dispositif pour l'analyse de défaillance et la commutation de redondance, d'une temporisation d'un temps préréglé avant que de l'énergie électrique soit appliquée sur la section de câble d'instrument suivante au moyen de commutation retardée des paires de conducteurs avant que de la tension soit appliquée sur la section de câble suivante.

3. Procédé selon la revendication 1, **caractérisé en ce que** l'étape b) comprend la mesure du niveau total de courant et de tension dans un intervalle de temps correspondant pour détecter si le dispositif pour l'analyse de défaillance et la commutation de redondance et la section de câble d'instrument suivante consomment un niveau correct et spécifié de courant et de tension.

4. Procédé selon une quelconque des revendications 1 à 3, **caractérisé en ce que** l'étape c) comprend en outre la considération de mesures locales de courant et de tension pour déterminer si la défaillance est présente dans la section de câble d'instrument, un dispositif de commande ou un autre équipement agencé sur le câble d'instrument.

5. Procédé selon une quelconque des revendications 1 à 4, **caractérisé en ce que** l'étape c) comprend en outre, si une défaillance est détectée, le contrôle que la paire de conducteurs peut être utilisée pour la transmission de données ou non.

6. Dispositif (21) pour l'analyse de défaillance et la commutation de redondance pour un câble d'instrument à sections multiples, tel qu'une flute sismique marine, lequel câble d'instrument à sections multiples comprend un nombre de paires de conducteurs (20a-b) pour l'alimentation en énergie électrique et le transfert de données, lequel dispositif (21) pour l'analyse de défaillance et la commutation de redondance est agencé en association avec une alimentation en énergie électrique pour le câble d'instrument à sections multiples, **caractérisé en ce que** le dispositif (21) pour l'analyse de défaillance et la commutation de redondance est pourvu de :
- moyens (22a-b) pour commander les sections de câble d'instrument à alimentation en énergie électrique, et une unité de temporisation (24) est connectée aux moyens (22a-b), lesquels moyens (22a-b) et laquelle unité de temporisation (24) sont agencés pour fournir successivement de l'énergie électrique aux sections de câble d'instrument et aux dispositifs (21) pour l'analyse de défaillance et la commutation de redondance le long du câble d'instrument,
- des moyens (23a-b) pour commuter l'alimentation en énergie électrique à une autre paire de conducteurs (20a-b) dans la section de câble d'instrument si une défaillance est détectée, et
- des moyens pour la mesure locale de courant et de tension dans les paires de conducteurs (20a-b).

7. Dispositif selon la revendication 6, **caractérisé en ce que** les moyens (22a-b) pour commander l'énergie électrique sont un ou plusieurs commutateurs principaux, un pour chaque paire de conducteurs (20a-b), ou un ou plusieurs commutateurs principaux multiples pour un nombre de paires de conducteurs (20a-b).

8. Dispositif selon la revendication 6, **caractérisé en ce que** les moyens (23a-b) pour commuter entre des paires de conducteurs (20a-b) dans le câble d'instrument sont un ou plusieurs commutateurs à croisement, un pour chaque paire de conducteurs (20a-b), ou un ou plusieurs commutateurs à croisement multiples pour un nombre de paires de conducteurs (20a-b).

9. Dispositif selon la revendication 6, **caractérisé en ce que** l'unité de temporisation (24) est implémentée par logiciel ou implémentée par matériel.

10. Dispositif selon une quelconque des revendications 6 à 9, **caractérisé en ce que** le dispositif (21) pour l'analyse de défaillance et la commutation de redondance comprend une unité de commande (25), sur laquelle les moyens (22a-b) pour commander l'énergie électrique, les moyens (23a-b) pour commuter entre des paires de conducteurs (20a-b) et l'unité de temporisation (24) sont agencés.

11. Dispositif selon une quelconque des revendications 6 à 10, **caractérisé en ce que** le dispositif (21) pour l'analyse de défaillance et la commutation de redondance est
- intégré dans ou agencé sur un dispositif de commande (13) pour commander la position d'un câble d'instrument,
- intégré dans ou agencé sur le câble d'instrument, par exemple par rapport à des connecteurs pour la connexion de sections de câble d'instrument, ou
- intégré dans ou agencé sur un équipement agencé sur le câble d'instrument.

12. Dispositif selon une quelconque des revendications 6 à 1l, **caractérisé en ce que** le dispositif (21) pour l'analyse de défaillance et la commutation de redondance est pourvu de moyens pour communiquer avec une unité centrale de commande agencée pour commander l'alimentation en énergie électrique et le transfert de données au câble d'instrument, et mesurer un niveau total de courant et de tension du câble d'instrument.
